(19) **Europäisches Patentamt / European Patent Office / Office européen des brevets**

(11) **EP 2 818 946 A1**

(12) **EUROPEAN PATENT APPLICATION**

(43) Date of publication:
    **31.12.2014 Bulletin 2015/01**

(51) Int Cl.:
    ***G04F 10/00*** (2006.01)

(21) Application number: **13305918.8**

(22) Date of filing: **28.06.2013**

(84) Designated Contracting States:
    **AL AT BE BG CH CY CZ DE DK EE ES FI FR GB GR HR HU IE IS IT LI LT LU LV MC MK MT NL NO PL PT RO RS SE SI SK SM TR**
    Designated Extension States:
    **BA ME**

(71) Applicant: **Asahi Kasei Microdevices Corporation Tokyo 101-8101 (JP)**

(72) Inventor: **Charpentier, Sebastien 14460 Colombelles (FR)**

(74) Representative: **Cabinet Plasseraud 52, rue de la Victoire 75440 Paris Cedex 09 (FR)**

(54) **Low quantization noise time-to-digital conversion**

(57)     There is described a time-to-digital conversion scheme using a first Time-to-Digital Converter, TDC (10), supplied by an analog TDC supply voltage and adapted to measure the duration of a level of an input signal (Imp), and a second TDC (20) supplied by the TDC supply voltage. A TDC supply voltage control loop including the second TDC is used to control the TDC power supply voltage (AVdd) so as to remove spurs stemming from high frequency quantization noise, from the output of the second TDC, and thus of the first TDC as well.

FIG.3

EP 2 818 946 A1

**Description**

**BACKGROUND**

**Technical Field**

The present invention generally relates to devices and methods for time-to-digital conversion, and more particularly to techniques for reducing the quantization noise of Time-to-Digital Converters.

**Related Art**

The approaches described in this section could be pursued, but are not necessarily approaches that have been previously conceived or pursued. Therefore, unless otherwise indicated herein, the approaches described in this section are not prior art to the claims in this application and are not admitted to be prior art by inclusion in this section.

A Time-to-Digital Converter (TDC) is an electronic device commonly used to measure a time interval between two events, namely the time between a start event and a stop event, and convert it into a digital output value (binary word). TDCs have become more and more popular in the circuit design community, and are used nowadays in an increasing number of applications for the design of various signal processing systems. For instance, in all-digital Phase-Locked Loops (PLL) used e.g. in frequency synthesizers, a TDC may serve as a phase detector. Other applications include TDC based Analog-to-Digital Converters (ADC).

Compared to original analog realizations which were based on a traditional approach that time-to-digital conversion is obtained by first converting the time interval into a voltage and then by digitizing this voltage by a conventional ADC, fully digital solutions are by far more robust.

For instance, the principle of operation of such fully digital solutions as counter based TDCs relies on the idea that the best solution to quantize a time interval is to count the cycles of a reference clock fitting into the interval. Such counter-based solutions, however, suffer the drawback that the oscillator frequency exhibits a high dependency on the power supply voltage.

International patent application WO 2013030466 A1 discloses a device for measuring the duration of a level of an electrical signal using two TDC units. One TDC is used for carrying out the desired measurement as such, the other being used for the calibration of the measurement TDC. The device thus comprises: a first ring oscillator consisting of inverting gates whose electrical power supply is modulated by the electrical signal, a second ring oscillator whose electrical power supply is not modulated by the electrical signal, means for counting the total number of transitions from gate to gate of a point of instability of the first ring oscillator, means for counting the total number of transitions from gate to gate of a point of instability of the second ring oscillator, and means for determining the duration of the level of the electrical signal on the basis of the values of the counting means. This way, measurement errors which are due to power supply instability, can be removed.

A TDC quantifies a time difference between two signal edges to a digital word of n bits. Like any Analog-to-Digital Converter (ADC), a TDC exhibits a quantification error due to its limited resolution. The quantization error generates some high frequency noise.

It is possible to use noise shaping techniques so that the quantization noise power is rejected towards high frequencies. This is particularly suited in the case of digital PLLs, since the loop filter of the PLL is adapted to remove the high frequency noise.

However, in some cases the TDC quantification noise can generate high-frequency spurs which can be down-converted in-band. This can happen in case of, e.g. some specific modulation pattern of the fractional division ratio of frequency divider arranged in the return path of the PLL.

**SUMMARY**

To present invention aims at providing an alternative solution for performing time-to-digital conversion with dithering.

A first aspect of the present invention thus relates to a time-to-digital conversion device for converting the duration of a given level of an electrical signal into a binary output value, the device comprising:

a first Time-to-Digital Converter, TDC, having a first ring oscillator comprising inverting gates supplied by a TDC supply voltage having a nominal value which is modulated by the electrical signal, and adapted to measure the duration of the level of the electrical signal by generating a first binary value with respect to the oscillating frequency of said first ring oscillator;

a second TDC, having a second ring oscillator comprising inverting gates supplied by the TDC supply voltage which is not modulated by the electrical signal, and adapted to generate a second binary value with respect to the oscillating frequency of said second ring oscillator; and,

a control loop for controlling the TDC power supply voltage, adapted to lock on the second binary value to a digital command whose value is tied to the nominal value of the TDC supply voltage.

Hence, the proposed solution allows removing high frequency quantization noise from the output of the first and second TDCs by regulating the TDC supply voltage to its target, i.e. nominal value.

In some embodiments, the device further comprises means for subtracting the second binary value from the first binary value, and for generating the binary output value with respect to a resulting binary difference value. This way, the second TDC may operate as a calibration TDC for compensating any supply voltage drift, as taught in WO 2013030466 A1.

The device may further comprise means for multiplying the second binary value by a given factor before the second binary value is subtracted from the first binary value. This multiplication factor allows using the proposed solution in applications where the inverting gates of the first ring oscillator differ in type and/or in number from the inverting gates of the second ring oscillator.

In some embodiment, the digital command may be programmable, for instance a changeable binary word stored in a programmable register. This allows the device to be used in a large number of applications without any modification of the hardware design being necessary.

The TDC supply voltage control loop may be a Phase-Locked-Loop, PLL, operating in the digital domain and adapted to regulate the TDC supply voltage to its nominal value. This provides a simple and efficient implementation.

In some embodiments, the TDC supply voltage control loop may comprise a Digital-to-Analog Converter, DAC, whose output range is centered around the target value of the TDC supply voltage with a dynamic between $\pm$ 1% at minimum and $\pm$ 10% at maximum. For example, the dynamic of the output range of the DAC is substantially $\pm$ 5% around the target value of the TDC supply voltage, which provides satisfying results.

A second aspect of the present invention relates to a method of time-to-digital conversion for converting the duration of a given level of an electrical signal into a binary output value, comprising:

measure the duration of the level of the electrical signal by generating a first binary value with respect to the oscillating frequency of a first ring oscillator of a first Time-to-Digital Converter, TDC, having a first ring oscillator, said first ring oscillator comprising inverting gates supplied by a TDC supply voltage having a nominal value which is modulated by the electrical signal;

generating a second binary value with respect to the oscillating frequency of a second ring oscillator of a second TDC, said second ring oscillator comprising inverting gates supplied by the TDC supply voltage which is not modulated by the electrical signal; and,

controlling the TDC power supply voltage using a control loop adapted to lock on the second binary value to a digital command whose value is tied to the nominal value of the TDC supply voltage.

According to some embodiments, the method may further comprise subtracting the second binary value from the first binary value, and generating the binary output value with respect to a resulting binary difference value.

In cases where the inverting gates of the first ring oscillator differ in type and/or in number from the inverting gates of the second ring oscillator, the method may further comprise multiplying the second binary value by a given factor before said second binary value is subtracted from the first binary value.

A third aspect of the present invention relates to a Phase Locked Loop (PLL) based frequency synthesizer, having a Phase/Frequency Detector (PFD) circuit comprising a time-to-digital conversion device according to the first aspect.

## BRIEF DESCRIPTION OF THE DRAWINGS

Embodiments of the present invention are illustrated by way of example, and not by way of limitation, in the figures of the accompanying drawings, in which like reference numerals refer to similar elements and in which:

- FIG.1 is a schematic block diagram of a PLL based frequency synthesizer adapted to embed the proposed time-to-digital conversion technique with two TDCs;

- FIG.2 is a schematic block diagram of a time-to-digital conversion device with two TDCs, to which the proposed embodiments relate;

- FIG.3 is a schematic block diagram of a TDC supply voltage control loop according to proposed embodiments;

- FIG.4 is a spectrum diagram illustrating the power density at the output of the calibration TDC of the device of FIG.2 in the case where the quantization noise is not removed by a control loop as shown in FIG.3; and,

- FIG.5 is a spectrum diagram illustrating the power density at the output of the calibration TDC of the device of FIG.2 in the case where the quantization noise is removed by a control loop as shown in FIG.3.

## DESCRIPTION OF PREFERRED EMBODIMENTS

In the accompanying drawing Figures and in the following description, like reference numbers designate like parts in various Figures.

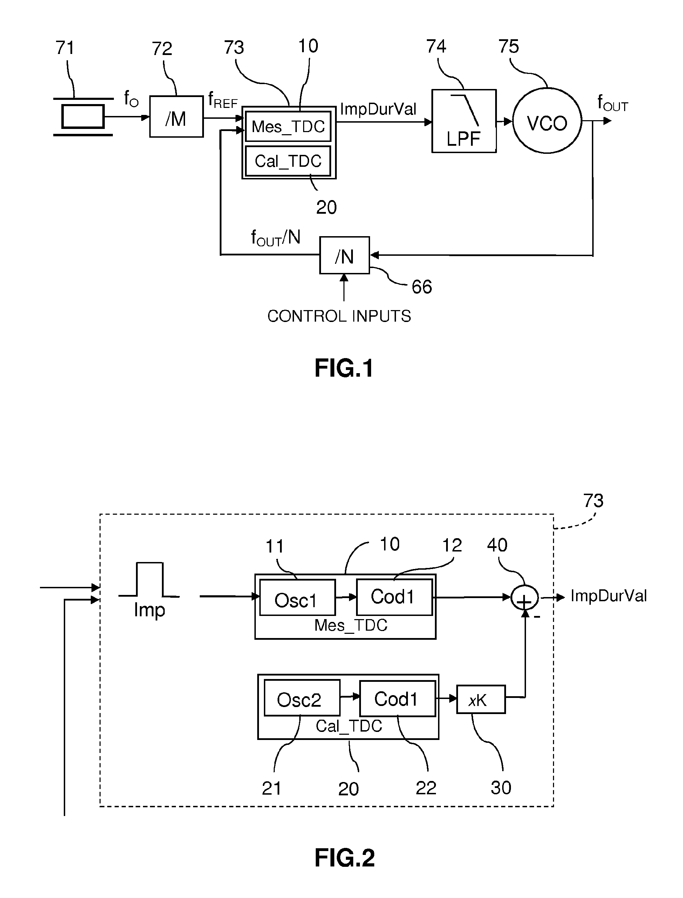

With reference to the circuit block diagram of **FIG.1,** the basic elements and arrangement of a PLL based frequency synthesizer are as follows.

These elements comprise a PFD circuit 73 which is adapted to compare the phases of two input signals, and produces an error signal that is representative of, for instance proportional to the difference between their phases. In the shown example, the PDF circuit comprises a Time-to-Digital Conversion device (TDC), so that the phase error signal takes the form of a binary word *ImpDurVal.*

The error signal is then low pass filtered in a Low Pass Filter (LPF) 74, for instance a digital filter, and used to drive a Voltage-Controlled Oscillator (VCO) 75, for instance a digitally controlled VCO, which creates an output frequency $f_{OUT}$. The output frequency $f_{OUT}$ is fed through a frequency divider 76 back to one input of the PFD, producing a negative feedback loop.

The frequency divider 76 is adapted to divide the output frequency $f_{OUT}$ by a given number $N$ to provide frequency at the input of the PFD. If the frequency $f_{OUT}/N$ shifts up or down, the phase error signal will decrease or increase, respectively, thus driving the output frequency $f_{OUT}$ of the VCO in the opposite direction so as to reduce the error. Thus, the output is locked to the frequency at the other input times $N$. This other input receives a fixed frequency which is called the reference frequency $f_{REF}$.

The reference frequency $f_{REF}$ may be derived from a crystal oscillator 71 generating a nominal frequency $f_0$ which is very stable, usually through a frequency divider 72 adapted to divide the nominal frequency $f_0$ by $M$, so that $f_{REF}=f_0/M$.

The device 73 quantifies a time difference between the signal at frequency $f_{REF}$ and the return signal at frequency $f_{OUT}/N$ to a digital word of $p$ bits. Like any Analog-to-Digital Converter (ADC), a Time-to-Digital Converter exhibits a quantification error which generates some high frequency noise.

The ability of the frequency synthesizer to generate multiple frequencies stems from digital inputs controlling the frequency divider 76 placed between the output and the feedback input, namely the division factor $N$. The division factor $N$ may be a fractional number.

With reference to **FIG.2** the PFD more specifically comprises an arrangement of two Time-to-Digital Converters (TDC) 10 and 20.

The first TDC 10, also named the "measurement TDC", is used for measuring the duration of, e.g. a high level of an electrical signal, namely a pulse Imp. The second TDC 20, also named the "calibration TDC", is adapted to and may have the effect of digitally removing any power supply noise which would generate some low frequency noise on the measurement TDC. This may be achieved by subtracting the digital word output by the calibration TDC 10 from the digital word output by the measurement TDC 20, using a subtraction operator 40, as taught in the document WO 2013030466 A1. The binary output value *ImpDurVal* at the output of the subtractor 40 is the desired duration measurement.

The measurement TDC may comprise a ring oscillator 11 comprising, for example, inverting gates whose electrical power supply is modulated by the electrical signal *Imp.* Because the running frequency of a ring oscillator is highly dependent on its supply voltage, the output frequency of the ring oscillator 11 is modified when the electrical signal *Imp* shifts from its high level to its low level, or *vice versa.* In one example, the nominal voltage AVdd of the power supply is 1,8 volts, and the supply voltage AVdd of the ring oscillator 11 is 95% of AVdd (i.e. approximately 1,7 volts) when the electrical signal *Imp* is at the high level, and is 70% of AVdd (i.e., 1,25 volts) when the electrical signal Imp is at the low level. An encoder 12 is adapted to periodically generate a digital information, e.g. a binary word which is representative of the duration of the high level of the pulse signal *Imp.* Thus, the TDC 10 carries out both time measurement and analog-to-digital conversion functions simultaneously and in combination.

The ring oscillators 11 and 21 of the measurement TDC 10 and of the calibration TDC 20, respectively, may be built from same delay elements, e.g. inverting gates. This provides simplicity for the technical realisation process. However, in some applications the type of the inverting gates of the ring oscillator 21 may differ from the type of the inverting gates of the ring oscillator 11.

Also, the respective numbers of inverting gates in the ring oscillator 11 and in the ring oscillator 21 may be different. In particular, the ring oscillator 11 of the calibration TDC 20 does not specifically need to have as much gates as the one of the measurement TDC 10. Therefore, in order to spare space on the chip, it can have less inverting gates.

In any one of the two above cases, or in both cases simultaneously such being the case, a multiplication factor K can be applied to the binary word output from the calibration TDC 20, by a K-multiplication operator 30, before subtraction from the binary word output from the measurement TDC 20 which is performed by operator 40.

In the embodiment as shown, the pulse whose duration is measured by the measurement TDC 10 is the pulse defined by the active edges, e.g. rising edges of the signal at the reference frequency $f_{REF}$ which is input to the PDF circuit 73 from the frequency divider 72, and the PLL feedback signal at the divided frequency $f_{OUT}/N$ which is input to the PDF circuit 73 from the N-fractional frequency divider 76.

The calibration TDC 20 comprises a free-running ring oscillator 21, whose electrical power supply is provided by the same supply voltage VDD as the measurement TDC 20 but is not modulated by the electrical signal *Imp.* By "supply voltage" of either one of the TDC 10 and the TDC 20, it must be understood the voltage supplying the inverting gates of said TDC.

The propagation delay of the inverting gates exhibits a substantial dependency to their supply voltage AVdd.

Embodiments rely on the idea of controlling the supply voltage AVdd by a control loop which includes the calibration TDC 20, in order to remove the quantization noise of said TDC. Changing the supply voltage of the inverting gates, indeed, will result in a change of their conversion gain. What is achieved is a correction of the output value of the TDC which nullifies the effects of the high frequency quantization noise. Because the same supply voltage AVdd is used for supplying both of the measurement TDC 10 and the calibration TDC 20, the same correction is applied simultaneously to the measurement TDC 10. Thus, the desired measurement of the duration of the signal *Imp* is more accurate, not being altered by the measurement TDC quantification noise.

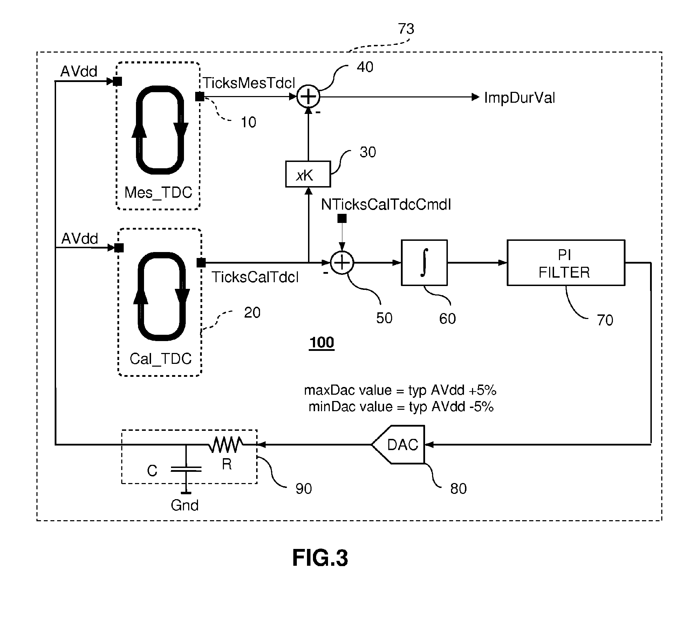

With reference to the circuit diagram of **FIG.3,** there will now be described an embodiment of the TDC power supply control loop 100. In the embodiment as shown, the supply voltage control loop is built in the digital domain. It will be appreciated by the one with ordinary skills in the art, however, that any other embodiment is possible, for instance mixing both digital and analog elements.

In the embodiment as shown, the TDC power supply control loop 100 is designed as a PLL which comprises a subtraction operator 50 having a first input connected to the output of the calibration TDC 10 for receiving the calibration TDC output digital signal *TicksCalTdcl,* and a second input for receiving a digital command signal *NTicksCalTdcCmdl.* In the digital domain, these signals are defined by successive binary words.

The calibration TDC output digital signal *TicksCalTdcl,* carries the information as to, e.g., the oscillation frequency of the ring oscillator 21 (see FIG.2). For instance, this frequency may be expressed as a number of "ticks" of the calibration TDC per time unit. It strongly depends on the supply voltage supplying the ring oscillator 11 of the measurement TDC 10 and the ring oscillator 21 and of the calibration TDC 20.

The digital command signal *NTicksCalTdcCmdl* is a number, e.g., an integral number having a given value.

As it will become more apparent to the skilled person from the description which follows, the TDC power supply control loop 100 is aimed at, and adapted to control the actual value AVdd of the voltage supply supplying both the measurement TDC and the calibration TDC. Thus, by using the above mentioned dependency, the quantization noise may be removed from, in particular, the measurement TDC 10. In other words, the proposed solution offers an additional use of the calibration TDC 20 by inserting it in a TDC power supply control loop adapted to remove the TDC quantization noise.

The command signal *NTicksCalTdcCmdl* may be programmable, for example it may be stored in a programmable register. In some embodiments, it may be programmed, for instance during a phase of operation provided for setting various parameters of the synthesizer. It may have a fixed value, or a variable value which depends, e.g. on the target, i.e. nominal value of the supply voltage AVdd intended for supplying the measurement TDC. In the latter case, it may be read from storing means such as a look-up table.

The digital signal at the output of the subtraction operator 50 is representative of the frequency error which is tied to the high frequency quantization noise of the TDC 20.

The subtraction operator 50 is followed by a digital integrator 60, which outputs a digital signal which is representative of the phase error, as a PLL operates on phase signals. This digital signal is composed of binary words.

It will be appreciated that other embodiments are possible. In some embodiments, indeed, the calibration and measurement TDC may be designed to directly issue output values which are representative of phase signals. In such cases, the command signal *NTicksCalTdcCmdl* may be a ramp signal, and no integrator such as integrator 60 shown in FIG.3 is necessary.

Back to the embodiment as shown in FIG.3, the digital phase error signal output by the integrator 60 is filtered by a digital filter 70, for instance a Proportional/Integral (PI) filter, which outputs binary words forming a digital control command for the TDC power supply control loop.

Said digital control command is then converted to analog by a Digital-to-Analog Circuit (DAC) 80. The DAC 80 is further adapted to scale up the analog control command signal toward the typical value of the power supply voltage AVdd which is used for supplying the ring oscillators of the measurement TDC 10 and the calibration TDC 20. Assuming that this typical value is denoted typ_AVdd, then the output range [minDAC_value;maxDAC_value] of the DAC 80 may be defined by:

$$\begin{cases} \text{minDac\_value} = \text{target AVdd} - 5\% \\ \text{maxDac\_value} = \text{target AVdd} + 5\% \end{cases} \tag{1}$$

The one with ordinary skills in the art will appreciated that this range of $\pm 5\%$ around the target value of the TDC supply voltage AVdd is purely an example. Other variation ranges, for example lying between $\pm$ 1% at minimum and $\pm$ 10% at maximum may be preferred depending on the specific application. The wider the variation range, the wider the operation range but the less accuracy of the TDC supply voltage control scheme.

The analog control signal output from the DAC 80 is then low-pass filtered in order to remove the noise introduced by the DAC. In the shown example, the control loop 100 comprises to that end an analog Low-Pass Filter (LPF) 90, for example a basic RC cell.

The output of the LPF 90 is directly the controlled supply voltage AVdd used for supplying the ring oscillators of both the measurement TDC 10 and the calibration TDC 20.

The command signal *NTicksCalTdcCmdl* being a quantified value, it follows that when the loop 100 is stabilized the *TicksCalTdcsl* output of the calibration TDC 20 gives only "integer" values. It results there from that any in-band spurs that would stem from high-frequency quantization noise are removed from the *TicksCalTdcsl* digital signal. The same is true as regards the *TicksMesTdcl* digital signal which is output from the measurement TDC 10. Indeed, any spurs stemming from high frequency quantization noise are removed from the output of the second TDC, and thus from the output of the first TDC as well since both TDC are supplied by the same supply voltage, namely the regulated AVdd voltage.

However, any residual low-frequency variations in the AVdd supply voltage that would remain would not affect the accuracy of the measurement by the measurement TDC 10 since the *TicksCalTdcsl* binary word is subtracted from the *TicksMesTdcl* binary word as taught in WO 2013030466 A1. Indeed, the function of the calibration TDC according to the teaching in WO 2013030466 A1 (namely, capturing power-supply variations) is not lost and may also be used in embodiments comprising the subtractor 40 and possibly also the multiplication module 30 as described above with reference to FIG.2.

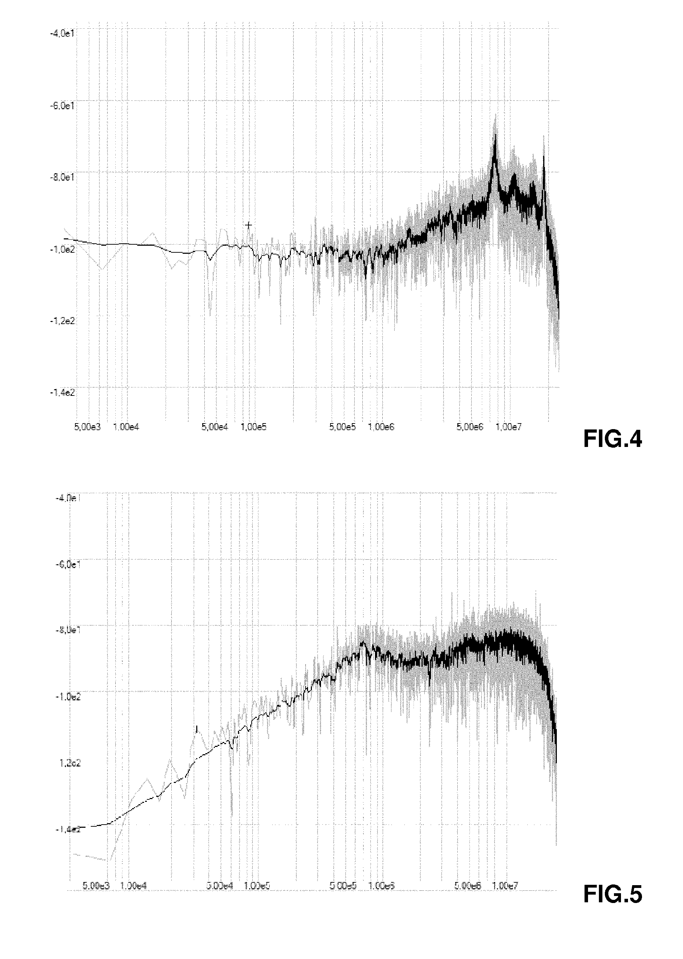

The graphs of **FIG.4** and **FIG.5** show the Power Density Spectrum (PDS) of the quantization noise in the digital signal *TicksCalTdcsl* at the output of the calibration TDC 20, without and with the implementation of embodiments of the invention, respectively. On these graphs, the power density (in dBc) is represented as a function of the frequency (in Hertz).

On the graph of FIG.4, a significant quantization noise of approximately -100dBc can be observed, in particular within the low frequency band. On the graph of FIG.5, on the contrary, the quantization noise at low frequencies starts from -140 dBc only. In other words, the implementation of embodiments of the invention provides attenuation by 40 dBc of the quantization noise stemming from the ADC function performed by the calibration TDC 20.

It will be appreciated by the one with ordinary skills in the art that all noise in the high frequency band is filtered by the loop filter of the PLL in which the device of FIG.3 is used, as shown for instance in FIG.1.

All remaining noise in the low frequency band is generated within the bandwidth of the system. In other words, there is no more spurs in the low frequency bandwidth that would have its origin in the high frequency band, like in particular the TDC quantization noise, and that would not be filtered out by the PLL provided by the proposed TDC supply voltage control loop 100.

The time-to digital conversion scheme as described in the above may be used in a wide range of electronic devices. For instance, it may be used in Phase/Frequency Detector (PFD) circuits as found in, e.g., frequency synthesizers operating according to the principle of fractional Phase Locked Loop (PLL).

Frequency synthesizers are electronic systems adapted to generate any of a range of frequencies which depends on the specific application. They are found in many modern devices, including radio emitters for mobile telephones, radiocommunication base stations, satellite receivers, GPS systems, and various other electronic applications.

Another aspect of the present disclosure relates to a method of time-to-digital conversion using a measurement TDC and a calibration TDC supplied by the same supply voltage, and a TDC supply voltage control loop as previously described.

Expressions such as "comprise", "include", "incorporate", "contain", "is" and "have" are to be construed in a non-exclusive manner when interpreting the description and its associated claims, namely construed to allow for other items or components which are not explicitly defined also to be present. Reference to the singular is also to be construed in be a reference to the plural and vice versa.

While there has been illustrated and described what are presently considered to be the preferred embodiments of the present invention, it will be understood by those skilled in the art that various other modifications may be made, and equivalents may be substituted, without departing from the true scope of the present invention. Additionally, many modifications may be made to adapt a particular situation to the teachings of the present invention without departing from the central inventive concept described herein. Furthermore, an embodiment of the present invention may not include all of the features described above. Therefore, it is intended that the present invention not be limited to the particular embodiments disclosed, but that the invention include all embodiments falling within the scope of the appended claims.

The one with ordinary skills in the art will recognize that the boundaries between logic blocks are merely illustrative and that alternative embodiments may merge logic blocks or circuit elements or impose an alternate decomposition of functionality upon various logic blocks or circuit elements.

In addition, a person skilled in the art will readily appreciate that various parameters disclosed in the description may be modified and that various embodiments disclosed and/or claimed may be combined without departing from the scope of the invention which is defined by the appended claims only.

It is finally stipulated that the reference signs in the claims do not limit the scope of the claims, but are merely inserted to enhance the legibility of the claims.

**Claims**

1. A time-to-digital conversion device, for converting the duration of a given level of an electrical signal (Imp) into a binary output value (ImpDurVal), comprising:

   a first Time-to-Digital Converter, TDC (10), having a first ring oscillator (11) comprising inverting gates supplied by a TDC supply voltage (AVdd) having a nominal value which is modulated by the electrical signal, and adapted to measure the duration of the level of the electrical signal by generating a first binary value (TicksMesTdcl) with respect to the oscillating frequency of said first ring oscillator;
   a second TDC (20), having a second ring oscillator (21) comprising inverting gates supplied by the TDC supply voltage which is not modulated by the electrical signal, and adapted to generate a second binary value (TicksCalTdcl) with respect to the oscillating frequency of said second ring oscillator; and,
   a control loop (100) for controlling the TDC power supply voltage, adapted to lock on the second binary value (TicksCalTdcl) to a digital command (NTicksCalTdcCmdl) which is tied to the nominal value of the TDC supply voltage.

2. The device of claim 1, comprising means (30) for subtracting the second binary value from the first binary value, and for generating the binary output value with respect to a resulting binary difference value.

3. The device of claim 2, wherein the inverting gates of the first ring oscillator differ in type and/or in number from the inverting gates of the second ring oscillator, the device further comprising means for multiplying the second binary value by a given factor before said second binary value being subtracted from the first binary value.

4. The device of any one of claims 1 to 3, wherein the digital command is programmable.

5. The device of any one of claims 1 to 4, wherein the TDC supply voltage control loop is a Phase-Locked-Loop, PLL, operating in the digital domain and adapted to regulate the TDC supply voltage to its nominal value.

6. The device of claim 5, wherein the TDC supply voltage control loop comprises a Digital-to-Analog Converter, DAC, whose output range is centered around the target value of the TDC supply voltage with a dynamic between $\pm$ 1% at minimum and $\pm$ 10% at maximum.

7. The device of claim 6, wherein the dynamic of the output range of the DAC is substantially $\pm$ 5% around the target value of the TDC supply voltage.

8. A method of time-to-digital conversion for converting the duration of a given level of an electrical signal (Imp) into a binary output value (ImpDurVal), comprising:

measure the duration of the level of the electrical signal by generating a first binary value (TicksMesTdcl) with respect to the oscillating frequency of a first ring oscillator (11) of a first Time-to-Digital Converter, TDC (10), having a first ring oscillator, said first ring oscillator comprising inverting gates supplied by a TDC supply voltage (AVdd) having a nominal value which is modulated by the electrical signal;

generating a second binary value (TicksCalTdcl) with respect to the oscillating frequency of a second ring oscillator (21) of a second TDC (20), said second ring oscillator comprising inverting gates supplied by the TDC supply voltage which is not modulated by the electrical signal; and,

controlling the TDC power supply voltage using a control loop (100) adapted to lock on the second binary value (TicksCalTdcl) to a digital command (NTicksCalTdcCmdl) whose value is tied to the nominal value of the TDC supply voltage.

9. The method of claim 8, further comprising subtracting the second binary value from the first binary value, and generating the binary output value with respect to a resulting binary difference value.

10. The method of claim 9, wherein the inverting gates of the first ring oscillator differ in type and/or in number from the inverting gates of the second ring oscillator, the method further comprising multiplying the second binary value by a given factor before said second binary value being subtracted from the first binary value.

11. The method of any one of claims 8 to 10, wherein the digital command is programmable.

12. Phase-Locked-Loop based frequency synthesizer having a Phase/Frequency Detector, PFD, circuit comprising a time-to-digital conversion device according to any one of claims 1 to 7.

FIG.1

FIG.2

73

AVdd

Mes_TDC
10

TicksMesTdcl

40

ImpDurVal
−

xK
30

NTicksCalTdcCmdl

AVdd

Cal_TDC
20

TicksCalTdcl
−

50

∫
60

PI
FILTER
70

**100**

maxDac value = typ AVdd +5%
minDac value = typ AVdd −5%

C    R
90

DAC
80

Gnd

FIG.3

FIG.4

FIG.5

Europäisches
Patentamt

European
Patent Office

Office européen
des brevets

**EUROPEAN SEARCH REPORT**

**Application Number**

EP 13 30 5918

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | WO 2013/030466 A1 (CRFTECH [FR]; CANARD DAVID [FR]; LECUYER MATTHIEU [FR]) 7 March 2013 (2013-03-07) * page 6, line 13 - page 8, line 29 * * figure 2 * * claims 1-9 * ----- | 1-12 | INV. G04F10/00 |
| A | US 2011/090015 A1 (SUMITA MASAYA [JP] ET AL) 21 April 2011 (2011-04-21) * paragraphs [0034], [0038] * * figure 1 * * paragraphs [0054] - [0056] * * figure 13 * ----- | 1-12 | |
| A | US 2011/304361 A1 (HENZLER STEPHAN [DE] ET AL) 15 December 2011 (2011-12-15) * paragraphs [0030] - [0036] * * figures 3,4 * ----- | 1-12 | |
| A | US 2006/103566 A1 (VEMULAPALLI SUDHEER K [US] ET AL) 18 May 2006 (2006-05-18) * the whole document * ----- | 1-12 | **TECHNICAL FIELDS SEARCHED (IPC)** G04F |

The present search report has been drawn up for all claims

| Place of search | Date of completion of the search | Examiner |
|---|---|---|
| The Hague | 17 December 2013 | Pirozzi, Giuseppe |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**ANNEX TO THE EUROPEAN SEARCH REPORT
ON EUROPEAN PATENT APPLICATION NO.**

EP 13 30 5918

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-2013

| Patent document cited in search report | Publication date | Patent family member(s) | | Publication date |
|---|---|---|---|---|
| WO 2013030466 A1 | 07-03-2013 | NONE | | |
| US 2011090015 A1 | 21-04-2011 | JP | 2010087275 A | 15-04-2010 |
| | | US | 2011090015 A1 | 21-04-2011 |
| | | WO | 2010038330 A1 | 08-04-2010 |
| US 2011304361 A1 | 15-12-2011 | NONE | | |
| US 2006103566 A1 | 18-05-2006 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013030466 A1